# EUROPÄISCHE PATENTSCHRIFT

(11) **EP 3 254 124 B1**
(45) Veröffentlichungstag und Bekanntmachung des Hinweises auf die Patenterteilung: **30.04.2025**
(21) Anmeldenummer: 16701515.5
(22) Anmeldetag: 26.01.2016
(51) Int. Cl.: G01R 31/62, G01R 27/26

(54) **VORRICHTUNG UND VERFAHREN ZUM ERMITTELN EINER KENNGRÖSSE EINES TRANSFORMATORS**
DEVICE AND METHOD FOR DETERMINING A PARAMETER OF A TRANSFORMER
DISPOSITIF ET PROCÉDÉ DE DÉTERMINATION D'UNE CARACTÉRISTIQUE D'UN TRANSFORMATEUR

(30) Priorität: 06.02.2015 AT 500922015
(43) Veröffentlichungstag der Anmeldung: 13.12.2017
(73) Patentinhaber: Omicron electronics GmbH, 6833 Klaus (AT)
(72) Erfinder: PÜTTER, Markus, 6832 Sulz (AT); SAPETSCHNIG, Rene, 6923 Lauterach (AT)
(74) Vertreter: Kraus & Lederer PartGmbB
(86) Internationale Anmeldenummer: PCT/EP2016/051544
(87) Internationale Veröffentlichungsnummer: WO 2016/124443

(56) Entgegenhaltungen:
- EP-A1- 2 787 357
- EP-A1- 3 213 095
- WO-A1-2009/018850
- WO-A1-2016/066701
- CN-A- 102 749 515

## Beschreibung

### GEBIET DER ERFINDUNG

Ausführungsbeispiele der Erfindung betreffen eine Vorrichtung und ein Verfahren zum Ermitteln wenigstens einer Kenngröße eines Transformators. Ausführungsbeispiele der Erfindung betreffen insbesondere derartige Vorrichtungen und Verfahren, die Rückschlüsse auf eine Reaktanz ermöglichen.

### HINTERGRUND

Transformatoren werden als Bestandteile von Energieversorgungsnetzen verwendet. Transformatoren können zur Spannungswandlung von einem ersten Wert an einer Oberspannungsseite zu einem zweiten Wert, der kleiner als der erste Wert ist, an einer Unterspannungsseite eingesetzt werden.

Die Bestimmung von Eigenschaften Transformators durch eine Transformatorprüfung, bei der eine oder mehrere charakteristische Kenngrößen des Transformators durch Messung ermittelt werden, ist beispielsweise zur Gewährleistung der Betriebssicherheit, zur Ansteuerung oder aus weiteren Gründen erforderlich. Beispiele für derartige Messungen beinhalten neben der Bestimmung eines statischen Widerstands oder eines Übersetzungsverhältnisses auch die Bestimmung einer Streuinduktivität oder Streureaktanz. Anhand der Streureaktanz können Abweichungen von den auf einem Datenblatt definierten Kenngrößen des Transformators erkannt werden, die beispielsweise durch eine Verformung einer Wicklung hervorgerufen werden können.

EP2787357 A1 offenbart ein Verfahren und eine Vorrichtung zum Testen eines Transformators oder Messwandlers, insbesondere zum Testen der Genauigkeit von Spannungswandlern. WO 2016/066701 A1 mit EP 3 213 095, das unter Artikel 54(3)

EPÜ fällt, offenbart eine Transformatorprüfvorrichtung und ein Verfahren zum Prüfen von Transformatoren. 1

Es besteht ein Bedarf an Vorrichtungen und Verfahren, mit denen wenigstens eine Kenngröße eines Transformators effizient ermittelt werden kann. Es besteht ein Bedarf an Vorrichtungen und Verfahren, die eine Automatisierung der Ermittlung derartiger Kenngrößen erlauben.

### ZUSAMMENFASSUNG DER ERFINDUNG

Die Erfindung ist definiert durch die Vorrichtung des unabhängigen Anspruchs 1 und das Verfahren des unabhängigen Anspruchs 10.

Nach Ausführungsbeispielen werden eine Vorrichtung und ein Verfahren zum Ermitteln einer Kenngröße eines Transformators angegeben, die eingerichtet sind, um ein Testsignal an einer Unterspannungsseite eines Transformators einzuprägen und abhängig von einer Testantwort eine Streureaktanz und/oder Streuinduktivität des Transformators zu ermitteln.

Eine derart ausgestaltete Vorrichtung und ein derart ausgestaltetes Verfahren stellen größere Flexibilität bei der Ermittlung von Kenngrößen bereit, da das Testsignal an der Unterspannungsseite eingeprägt wird. Die Streureaktanz und/oder die Streuinduktivität kann bzw. können automatisch ermittelt werden. Die Streureaktanz und/oder die Streuinduktivität kann bzw. können ermittelt werden, ohne dass dazu eine Umverdrahtung der Verbindungen zwischen den Transformatorprüfvorrichtung und dem Transformator unbedingt erforderlich ist.

Die Vorrichtung, mit der die Kenngröße ermittelt wird, umfasst ein steuerbares Schaltmittel, mit dem eine Oberspannungsseite des Transformators kurzgeschlossen wird, während das Testsignal an der Unterspannungsseite eingeprägt wird. Eine automatische, sequentielle Ermittlung mehrerer Kenngrößen wird dadurch erleichtert.

Die Quelle der Transformatorprüfvorrichtung kann so ausgestaltet sein, dass sie selektiv als Stromquelle oder als Spannungsquelle betreibbar ist.

Das steuerbare Schaltmittel kann ein Relais sein oder kann ein Relais umfassen. Das steuerbare Schaltmittel kann ein Bipolartransistor mit isolierter Gate-Elektrode (IGBT) oder ein Feldeffekttransistor (FET) sein oder kann einen IGBT oder einen FET umfassen.

Eine Vorrichtung ist zum Ermitteln einer Kenngröße eines Transformators, der eine Oberspannungsseite und eine Unterspannungsseite aufweist, eingerichtet. Die Vorrichtung umfasst Anschlüsse zur lösbaren Verbindung der Vorrichtung mit der Unterspannungsseite des Transformators. Die Vorrichtung umfasst eine Quelle zum Erzeugen eines Testsignals, die mit den Anschlüssen gekoppelt ist, um das Testsignal an der Unterspannungsseite des Transformators einzuprägen. Die Vorrichtung umfasst eine Auswerteeinrichtung, die eingerichtet ist, um eine Streureaktanz und/oder eine Streuinduktivität des Transformators in Abhängigkeit von einer Testantwort des Transformators zu bestimmen.

Die Auswerteeinrichtung kann wenigstens eine integrierte Halbleiterschaltung umfassen, die die Testantwort auswertet.

Die Vorrichtung umfasst weitere Anschlüsse zur lösbaren Verbindung der Vorrichtung mit der Oberspannungsseite des Transformators.

Die Vorrichtung kann eine mit den weiteren Anschlüssen gekoppelte Messeinrichtung zum Erfassen der Testantwort umfassen. Die Messeinrichtung kann ein Voltmeter umfassen.

Die Vorrichtung umfasst ein mit den weiteren Anschlüssen verbundenes steuerbares Schaltmittel zum Kurzschließen der Oberspannungsseite.

Das steuerbare Schaltmittel kann in ein Gehäuse der Vorrichtung integriert sein. Das steuerbare Schaltmittel kann ein Relais oder ein anderer Schalter, der zum Schalten eines Lastkreises unter Kontrolle eines Steuerkreises eingerichtet ist, sein. Das steuerbare Schaltmittel kann ein Bipolartransistor mit isolierter Gate-Elektrode (IGBT) oder ein Feldeffekttransistor (FET) sein oder kann einen IGBT oder einen FET umfassen.

Die Vorrichtung ist eingerichtet, um das steuerbare Schaltmittel so zu steuern, dass die Oberspannungsseite kurzgeschlossen ist, während das Testsignal an der Unterspannungsseite eingeprägt wird.

Die Auswerteeinrichtung kann eingerichtet sein, um die Streureaktanz und/oder die Streuinduktivität des Transformators in Abhängigkeit von der Testantwort und in Abhängigkeit von einer Reaktanz und/oder einer Induktivität wenigstens einer Leitung, die die weiteren Anschlüsse mit der Oberspannungsseite verbindet, zu bestimmen.

Die Auswerteeinrichtung kann eingerichtet sein, um die Reaktanz und/oder die Induktivität der wenigstens einen Leitung automatisch zu bestimmen.

Die Vorrichtung kann eingerichtet sein, um die Reaktanz und/oder die Induktivität der wenigstens einen Leitung ohne Umverdrahtung zwischen der Vorrichtung und dem Transformator zu bestimmen.

Die Auswerteeinrichtung kann eingerichtet sein, um aus der Testantwort eine Gesamtreaktanz, die durch die Leitungen und die Streureaktanz des Transformators verursacht wird, zu bestimmen, und aus der Gesamtreaktanz und der Reaktanz der wenigstens einen Leitung die Streureaktanz zu bestimmen.

Die Auswerteeinrichtung kann eingerichtet sein, um eine Kurzschlussimpedanz des Transformators in Abhängigkeit von der Testantwort des Transformators zu bestimmen.

Die Auswerteeinrichtung kann eingerichtet sein, um die Kurzschlussimpedanz des Transformators in Abhängigkeit von der Testantwort und in Abhängigkeit von einer Impedanz wenigstens einer Leitung, die die weiteren Anschlüsse mit der Oberspannungsseite verbindet, zu bestimmen.

Die Auswerteeinrichtung kann eingerichtet sein, um aus der Testantwort eine Gesamt-Impedanz, die durch die Leitungen und die Streuimpedanz des Transformators verursacht wird, zu bestimmen, und aus der Gesamtimpedanz und der Impedanz der wenigstens einen Leitung die Streuimpedanz zu bestimmen.

Die Vorrichtung kann eingerichtet sein, um einen Übertragungsfaktor des Transformators zu bestimmen. Die Auswerteeinrichtung kann eingerichtet sein, um die Streureaktanz in Abhängigkeit von dem Übertragungsfaktor zu bestimmen.

Die Vorrichtung kann eine Benutzerschnittstelle umfassen. Die Auswerteeinrichtung kann eingerichtet sein, um als Antwort auf eine Eingabe an der Benutzerschnittstelle die Streureaktanz und/oder die Streuinduktivität des Transformators zu ermitteln.

Die Benutzerschnittstelle kann so eingerichtet sein, dass über die Benutzerschnittstelle ein Ersatzschaltbild des Transformators anzeigbar ist. Die Benutzerschnittstelle kann eingerichtet sein, um über die Benutzerschnittstelle das Ersatzschaltbild mit Angabe der bestimmten Streureaktanz und/oder der Streuinduktivität darzustellen.

Die Auswerteeinrichtung kann eingerichtet sein, um abhängig von der Streureaktanz und/oder der Streuinduktivität des Transformators Abweichungen zu den Nenndaten des Transformators zu erkennen. Die Nenndaten können in einem Speicher der Vorrichtung nicht-flüchtig hinterlegt oder können von der Vorrichtung automatisch von einem fernen Speicher abgerufen werden. Alternativ oder zusätzlich kann die Vorrichtung eingerichtet sein, um über eine Benutzerschnittstelle die Nenndaten zu empfangen. Die Vorrichtung kann eingerichtet sein, um die Nenndaten abhängig von einer Benutzereingabe, mit der der Typ des Transformators angegeben wird, abzurufen und mit der ermittelten Streureaktanz und/oder der Streuinduktivität des Transformators zu vergleichen. Die Vorrichtung kann eingerichtet sein, um abhängig von dem Vergleich Information über eine Abweichung zwischen den Nenndaten und der ermittelten Streureaktanz und/oder der Streuinduktivität des Transformators auszugeben.

Die Vorrichtung kann als ein mobiles Transformatorprüfgerät ausgestaltet sein.

Die Vorrichtung kann als ein portables Transformatorprüfgerät ausgestaltet sein.

Ein System nach einem Ausführungsbeispiel umfasst einen Transformator, der eine Oberspannungsseite und eine Unterspannungsseite aufweist. Das System umfasst eine Vorrichtung nach einem Ausführungsbeispiel, die mit dem Transformator verbunden ist.

Ein Verfahren ist zum Ermitteln einer Kenngröße eines Transformators, der eine Oberspannungsseite und eine Unterspannungsseite aufweist, eingerichtet. Das Verfahren umfasst ein Einprägen eines Testsignals an der Unterspannungsseite. Das Verfahren umfasst ein Erfassen einer Testantwort des Transformators. Das Verfahren umfasst ein Bestimmen einer Streureaktanz und/oder einer Streuinduktivität des Transformators in Abhängigkeit von der Testantwort des Transformators.

Das Testsignal kann ein Wechselstromsignal oder ein Wechselspannungssignal sein.

Das Verfahren kann von einer Vorrichtung ausgeführt werden, die Anschlüsse zur lösbaren Verbindung mit der Unterspannungsseite des Transformators zum Einprägen des Testsignals und weitere Anschlüsse zur lösbaren Verbindung der Vorrichtung mit der Oberspannungsseite des Transformators aufweist.

Bei dem Verfahren kann die Vorrichtung eine mit den weiteren Anschlüssen gekoppelte Messeinrichtung zum Erfassen der Testantwort umfassen. Die Messeinrichtung kann ein Voltmeter umfassen.

Das Verfahren kann ein Kurzschließen der Oberspannungsseite durch ein steuerbares Schaltmittel der Vorrichtung umfassen.

Bei dem Verfahren kann das steuerbare Schaltmittel in ein Gehäuse der Vorrichtung integriert sein. Bei dem Verfahren kann das steuerbare Schaltmittel ein Relais oder ein anderer Schalter, der zum Schalten eines Lastkreises unter Kontrolle eines Steuerkreises eingerichtet ist, sein. Bei dem Verfahren kann das steuerbare Schaltmittel ein Bipolartransistor mit isolierter Gate-Elektrode (IGBT) oder ein Feldeffekttransistor (FET) sein oder kann einen IGBT oder einen FET umfassen.

Das Verfahren umfasst ein Steuern des steuerbaren Schaltmittels, so dass die Oberspannungsseite kurzgeschlossen wird, während das Testsignal an der Unterspannungsseite eingeprägt wird.

Bei dem Verfahren kann die Streureaktanz und/oder die Streuinduktivität des Transformators in Abhängigkeit von der Testantwort und in Abhängigkeit von einer Reaktanz und/oder einer Induktivität wenigstens einer Leitung, die die weiteren Anschlüsse mit der Oberspannungsseite verbindet bestimmt werden.

Bei dem Verfahren kann die Reaktanz und/oder die Induktivität von Leitungen zwischen der Vorrichtung und dem Transformator automatisch von der Vorrichtung bestimmt werden.

Bei dem Verfahren kann die Reaktanz und/oder die Induktivität der wenigstens einen Leitung ohne Umverdrahtung zwischen der Vorrichtung und dem Transformator bestimmt werden.

Bei dem Verfahren kann die Vorrichtung aus der Testantwort eine Gesamtreaktanz, die durch die Leitungen und die Streureaktanz des Transformators verursacht wird, bestimmen. Bei dem Verfahren kann die Vorrichtung aus der Gesamtreaktanz und der Reaktanz der wenigstens einen Leitung die Streureaktanz bestimmen.

Bei dem Verfahren kann von der Vorrichtung eine Kurzschlussimpedanz des Transformators in Abhängigkeit von der Testantwort des Transformators bestimmt werden.

Bei dem Verfahren kann von der Vorrichtung die Kurzschlussimpedanz des Transformators in Abhängigkeit von der Testantwort und in Abhängigkeit von einer Impedanz wenigstens einer Leitung, die die weiteren Anschlüsse mit der Oberspannungsseite verbindet, zu bestimmen.

Bei dem Verfahren kann von der Vorrichtung aus der Testantwort eine GesamtImpedanz, die durch die Leitungen und die Streuimpedanz des Transformators verursacht wird, bestimmt werden. Bei dem Verfahren kann von der Vorrichtung aus der Gesamtimpedanz und der Impedanz der wenigstens einen Leitung die Streuimpedanz bestimmt werden.

Bei dem Verfahren kann von der Vorrichtung ein Übertragungsfaktor des Transformators bestimmt werden. Die Streureaktanz kann in Abhängigkeit von dem Übertragungsfaktor bestimmt werden, beispielsweise durch Umrechnung gestrichener Transformator-Kenngrößen in ungestrichene Transformator-Kenngrößen.

Bei dem Verfahren kann als Antwort auf eine Eingabe an einer Benutzerschnittstelle die Streureaktanz und/oder die Streuinduktivität des Transformators ermittelt werden.

Bei dem Verfahren kann über die Benutzerschnittstelle ein Ersatzschaltbild des Transformators angezeigt werden. Optional kann eine ermittelte Streureaktanz und/oder Streuinduktivität in dem Ersatzschaltbild dargestellt werden.

Bei dem Verfahren kann abhängig von der Streureaktanz und/oder der Streuinduktivität des Transformators Abweichungen zu den Nenndaten des Transformators erkannt werden. Die Nenndaten können in einem Speicher der die Prüfung ausführenden Vorrichtung nicht-flüchtig hinterlegt sein oder können von der Vorrichtung automatisch von einem fernen Speicher abgerufen werden. Alternativ oder zusätzlich können über eine Benutzerschnittstelle die Nenndaten empfangen werden, um dem Benutzer die Eingabe der Nenndaten zu ermöglichen. Bei dem Verfahren können die Nenndaten abhängig von einer Benutzereingabe, mit der der Typ des Transformators angegeben wird, abgerufen und mit der ermittelten Streureaktanz und/oder der Streuinduktivität des Transformators verglichen werden. Abhängig von dem Vergleich kann Information über eine Abweichung zwischen den Nenndaten und der ermittelten Streureaktanz und/oder der Streuinduktivität des Transformators ausgegeben werden.

Die Vorrichtung, mit der das Verfahren ausgeführt wird, kann als ein mobiles Transformatorprüfgerät ausgestaltet sein.

Die Vorrichtung, mit der das Verfahren ausgeführt wird, kann als ein portables Transformatorprüfgerät ausgestaltet sein.

Das Verfahren kann von der Vorrichtung nach einem Ausführungsbeispiel ausgeführt werden.

Vorrichtungen, Verfahren und Systeme nach Ausführungsbeispielen erlauben eine effiziente Ermittlung einer Streureaktanz und/oder Streuinduktivität eines Transformators. Vorrichtungen, Verfahren und Systeme nach Ausführungsbeispielen erlauben die Ermittlung zusätzlicher Parameter bei einer Prüfung, ohne hierfür elektrische Leitungen zwischen der Vorrichtung und dem Prüfling umverdrahten zu müssen. Dadurch kann die Prüfung schneller ausgeführt werden. Mit Vorrichtungen, Verfahren und Systeme nach Ausführungsbeispielen kann während wenigstens eines Teils einer Prüfung ein niederohmiger Kurzschluss erzeugt werden, um ein unverfälschtes Prüfungsergebnis zu erreichen.

### KURZE BESCHREIBUNG DER FIGUREN

Die Erfindung wird nachfolgend unter Bezugnahme auf die Zeichnungen anhand bevorzugter Ausführungsformen näher erläutert. In den Zeichnungen bezeichnen identische Bezugszeichen identische Elemente.
Figur 1 zeigt ein System mit einer Vorrichtung nach einem Ausführungsbeispiel.
Figur 2 zeigt ein System mit einer Vorrichtung nach einem Ausführungsbeispiel.
Figur 3 zeigt ein Ersatzschaltbild eines Transformators zur Erläuterung der Funktionsweise der Vorrichtung nach einem Ausführungsbeispiel.
Figur 4 zeigt ein Ersatzschaltbild eines Transformators zur Erläuterung der Funktionsweise der Vorrichtung nach einem Ausführungsbeispiel.
Figur 5 ist ein Flussdiagramm eines Verfahrens nach einem Ausführungsbeispiel.

### DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein.

Nachfolgend werden Vorrichtungen und Verfahren zum Ermitteln einer Kenngröße eines Transformators detailliert beschrieben. Der Transformator kann ein Transformator für Hoch- oder Mittelspannungsnetze sein. Der Transformator kann ein in einem Kraftwerk oder Umspannwerk installierter Transformator sein. Die Vorrichtung kann ein mobiles Gerät sein, das die Durchführung der Messungen an dem installierten Transformator erlaubt.

Die Vorrichtung ist eingerichtet, um eine Streureaktanz und/oder Streuinduktivität des Transformators zu ermitteln. Dazu wird ein Testsignal, beispielsweise ein Wechselstrom, an der Sekundärseite eingespeist. Die Vorrichtung kann eine Testantwort erfassen. Eine Phasenlage der Testantwort relativ zu dem Testsignal kann ausgewertet werden, um die Streuinduktivität zu ermitteln. Die Auswertung der Testantwort kann automatisch durch eine Auswerteeinrichtung der Vorrichtung erfolgen.

Bei Vorrichtungen und Verfahren können die Reaktanz und/oder Induktivität wenigstens einer Leitung zwischen der Vorrichtung und dem Transformator berücksichtigt werden, um die Streureaktanz und/oder die Streuinduktivität des Transformators zu ermitteln. Die Testantwort kann beispielsweise eine erste erfasste Spannung und eine zweite erfasste Spannung umfassen. Aus der Größe und der Phasenlage der ersten erfassten Spannung und der zweiten erfassten Spannung kann sowohl die Reaktanz und/oder die Induktivität der Leitung zwischen der Vorrichtung und dem Transformator als auch die Streureaktanz und/oder die Streuinduktivität des Transformators bestimmt werden.

Die Vorrichtung kann weitere Kenngrößen des Transformators automatisch ermitteln. Beispielsweise kann die Vorrichtung eingerichtet sein, um ein Übersetzungsverhältnis des Transformators automatisch zu ermitteln. Das Übersetzungsverhältnis kann bei der Berechnung der Streureaktanz und/oder die Streuinduktivität verwendet werden, beispielsweise um eine Konversion von so genannten gestrichenen Kenngrößen in ungestrichene Kenngrößen des Transformators vorzunehmen. Die entsprechende rechnerische Verarbeitung kann automatisch von der Auswerteeinrichtung der Vorrichtung vorgenommen werden.

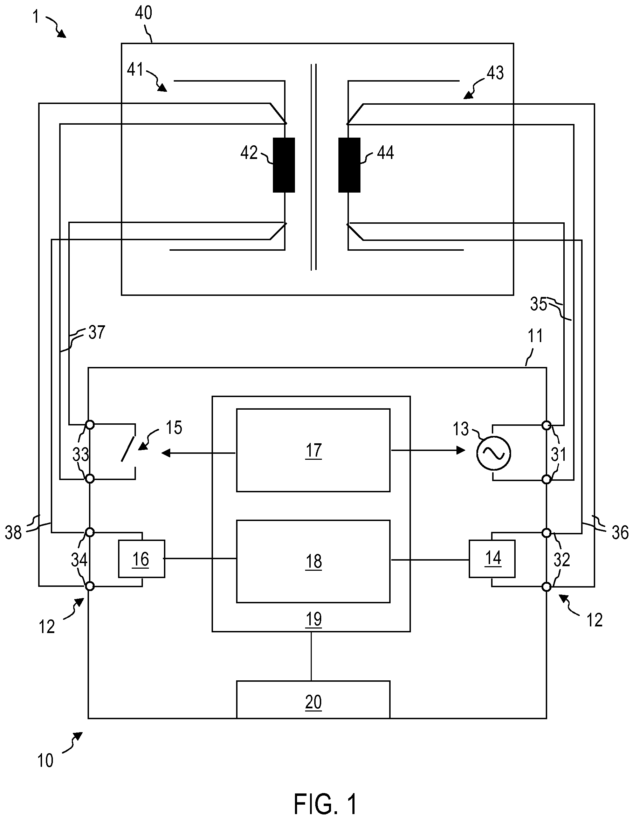

Figur 1 zeigt ein System 1 mit einer Vorrichtung 10 zum Ermitteln einer Kenngröße eines Transformators 40 nach einem Ausführungsbeispiel.

Das System 1 umfasst einen Transformator 40 und die Vorrichtung 10. Die Vorrichtung 10 kann als ein einziges Gerät mit einem Gehäuse 11 ausgebildet sein. Die Vorrichtung 10 kann aus einer Anordnung von mehreren Geräten oder Einrichtungen bestehen. Die mehreren Geräte oder Einrichtungen können in diesem Fall von einer zentralen Steuerung gesteuert werden. Die Vorrichtung 10 kann als mobiles Gerät und insbesondere als portables Gerät ausgebildet sein. Falls die Vorrichtung 10 aus mehreren Geräten besteht, kann jedes der Geräte als portables Gerät ausgebildet sein.

Der Transformator 40 kann ein Leistungstransformator einer elektrischen Energieversorgungseinrichtung sein. Der Transformator 40 kann fest in einem Kraftwerk oder Umspannwerk verbaut sein, während mit der Vorrichtung 10 eine Transformatorprüfung ausgeführt wird. Der Transformator 40 kann ein Spannungswandler oder Stromwandler sein. Der Transformator 40 kann ein Spannungswandler oder Stromwandler sein, der nach induktivem Wirkprinzip arbeitet.

Der Transformator 40 umfasst wenigstens eine erste Wicklung 42 und wenigstens eine zweite Wicklung 44. Die wenigstens eine erste Wicklung 42 kann an einer Oberspannungsseite 41 des Transformators 40 vorgesehen sein. Die wenigstens eine zweite Wicklung 44 kann an einer Unterspannungsseite 43 vorgesehen sein. Der Transformator 40 kann optional auch eine tertiäre Wicklung aufweisen.

Die Vorrichtung 10 umfasst eine Mehrzahl von Anschlüssen 12 zur Verbindung mit dem Transformator 40, eine Quelle 13 für ein Testsignal, das an den Transformator 40 als Prüfling bei der Transformatorprüfung angelegt oder eingeprägt wird, und eine Auswerteeinrichtung 18. Eine oder mehrere Messeinrichtungen 14, 16 zum Erfassen einer Testantwort des Transformators 40 können in die Vorrichtung 10 integriert sein.

Die Mehrzahl von Anschlüssen 12 umfasst Anschlüsse 31, die für eine Kopplung mit der Unterspannungswicklung 44 des Transformators 40 eingerichtet sind. Die Quelle 13 ist mit den Anschlüssen 31 gekoppelt, um das Testsignal an der Unterspannungsseite 43 einzuprägen. Die Mehrzahl von Anschlüssen 12 umfasst weitere Anschlüsse 33, 34, die für eine Kopplung mit der Oberspannungswicklung eingerichtet sind. Die Messeinrichtung 14 kann über Leitungen 36 mit der Unterspannungsseite 43 verbunden sein. Die Messeinrichtung 16 kann über Leitungen 38 mit der Oberspannungsseite 41 verbunden sein. Die Verbindung zwischen der Vorrichtung 10 und dem Transformator 40 kann lösbar sein, um eine Ermittlung von Kenngrößen im Feldeinsatz zu ermöglichen.

Die Auswerteeinrichtung 18 ist eingerichtet, um die Testantwort des Transformators 40 auszuwerten, um eine Streureaktanz und/oder eine Streuinduktivität des Transformators 40 zu bestimmen, wie nachfolgend noch ausführlicher beschrieben wird.

Die Quelle 13 kann eine Stromquelle sein, die steuerbar ist, um einen Wechselstrom als Testsignal zu erzeugen. Die Quelle 13 kann steuerbar sein, um Wechselströme mit mehreren unterschiedlichen Frequenzen als Testsignal zu erzeugen. Die Quelle 13 kann auch eine Spannungsquelle sein. Die Quelle 13 kann in unterschiedlichen Betriebsmodi betreibbar sein, beispielsweise als Stromquelle oder als Spannungsquelle und/oder als Quelle eines zeitlich konstanten Signals oder eines Wechselsignals. Das von der Quelle 13 erzeugte Testsignal kann über die Anschlüsse 13 und die Leitungen 35 an der Unterspannungsseite 43 eingeprägt werden.

Die Vorrichtung 10 kann weitere Einrichtungen umfassen. Die Vorrichtung 10 umfasst eine Steuereinrichtung 17 zum automatischen elektrischen Steuern der Quelle 13. Die erste Messeinrichtung 14 und die zweite Messeinrichtung 16 können beispielsweise jeweils für eine Spannungsmessung eingerichtet sein. Die Funktionen der Steuereinrichtung 17 und/oder der Auswerteeinrichtung 18 können von einem Prozessor 19 oder einer anderen integrierten Halbleitschaltung 19 ausgeführt werden.

Die Vorrichtung 10 umfasst ein steuerbares Schaltmittel 15. Das steuerbare Schaltmittel 15 kann eingerichtet sein, um die Oberspannungswicklung 42 selektiv kurzzuschließen. Auf diese Weise kann die Testantwort des Transformators für einen Kurzschluss an der Oberspannungsseite 41 erfasst werden. Es kann auch die Testantwort sowohl für einen Kurzschluss an der Oberspannungsseite 41 als auch im Leerlauf für einen offenen Schalter 15 erfasst werden. Das steuerbare Schaltmittel 15 wird von der Steuereinrichtung 18 automatisch angesteuert. Das steuerbare Schaltmittel 15 kann über weitere Anschlüsse 33 und Leitungen 37 zwischen den weiteren Anschlüssen 33 und der Oberspannungswicklung 42 mit der Oberspannungswicklung 42 leitend verbunden sein. Das steuerbare Schaltmittel 15 kann ein konventioneller Schalter, ein mechanisch - elektrischer Schalter, ein Relais, ein FET, ein IGBT oder eine andere Komponente sein, welche geeignet ist, eine elektrisch leitende Verbindung zwischen den Anschlüssen 33 abhängig von einem Zustand des Schaltmittels 15 herzustellen.

Die Vorrichtung 10 kann die Streureaktanz und/oder Streuinduktivität des Transformators 40 auf unterschiedliche Weise bestimmen. Die Steuereinrichtung 17 steuert die Quelle 13 so, dass das Testsignal an der Unterspannungsseite 43 eingeprägt wird. Das Testsignal kann ein Wechselstromsignal sein. Es können sequentiell unterschiedliche Frequenzen des Wechselstromsignals benutzerdefiniert oder automatisch eingestellt werden.

Die Vorrichtung 10 kann die Amplitude und Phasenlage einer Testantwort des Transformators 40 ermitteln. Beispielsweise kann mit einer Messeinrichtung 14 eine Spannung an der Unterspannungsseite 43 als eine erste Testantwort erfasst werden. Mit einer weiteren Messeinrichtung 16 kann eine Spannung an der Oberspannungsseite 41 als zweite Testantwort erfasst werden. Die Vorrichtung 10 kann die Phasenlage sowohl der ersten Testantwort als auch der zweiten Testantwort relativ zu dem Testsignal der Quelle 13 bestimmen. Dies kann auf unterschiedliche Weise ausgeführt werden. Beispielsweise kann ein Zeitabstand zwischen Nulldurchgängen des Testsignals und der Testantworten erkannt werden. Es kann ein Zeitabstand zwischen einem Nulldurchgang des Testsignals und einem Nulldurchgang einer Referenzsignals bestimmt werden, und es können weitere Zeitabstände zwischen einem Nulldurchgang jeder der Testantworten und dem Referenzsignal bestimmt werden. Aus den Zeitabständen und der Frequenz des Referenzsignals kann die Phasenlage bestimmt werden. Alternativ oder zusätzlich kann eine Multiplikation von Testsignal und Testantwort in Kombination mit zeitlicher Mittelung verwendet werden, um die Phasenlage aus dem zeitlichen Mittelwert und den Amplituden der multiplizierten Signale zu bestimmen.

Die Vorrichtung 10 kann die Amplitude einer oder mehrerer Testantworten automatisch bestimmen. Die Auswerteeinrichtung 18 kann einen Quotienten aus Amplitude einer Testantwort und Testsignalamplitude berechnen.

Die Auswerteeinrichtung 18 kann die gesamte Längsreaktanz des Transformators aus der Phasenverschiebung der ersten Testantwort relativ zum Testsignal, der Phasenverschiebung der zweiten Testantwort relativ zum Testsignal und den Amplituden ersten und zweiten Testantworten bestimmen. Die Auswerteeinrichtung 18 kann die gesamte Längsreaktanz als gestrichene Kenngröße des Transformators 40 ermitteln. Die Auswerteeinrichtung 18 kann optional eingerichtet sein, um durch Skalierung mit dem Quadrat des Übersetzungsverhältnisses des Transformators 40 die gesamte Längsreaktanz als ungestrichene Kenngröße zu bestimmen.

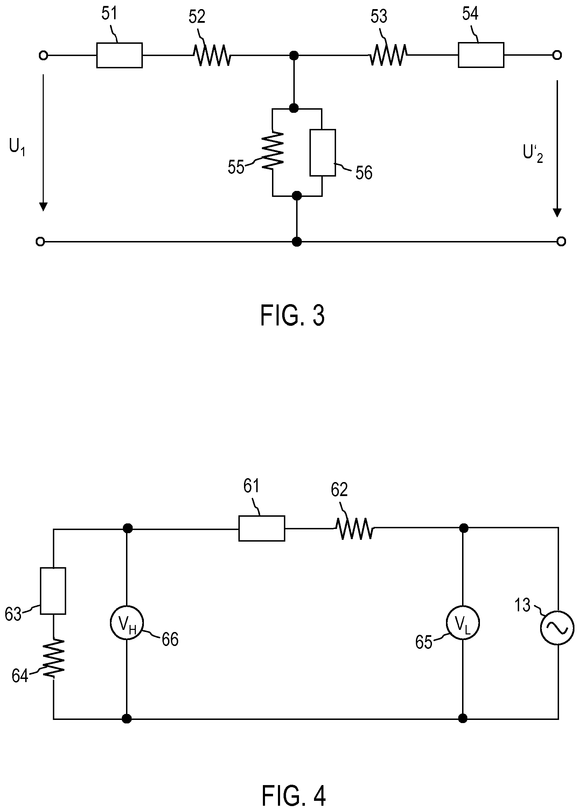

Bei einer Ausgestaltung kann, wie unter Bezugnahme auf Figur 4 noch ausführlicher beschrieben wird, die Auswerteeinrichtung 18 eingerichtet sein, um eine GesamtImpedanz, die die Summe der Längsimpedanz des Transformators und der Impedanz der Leitungen 37 ist, aus der Phasenlage und Amplitude der mit der Auswerteeinrichtung 14 erfassten Spannung zu bestimmen. Die Auswerteeinrichtung 18 kann eingerichtet sein, um die Impedanz der Leitungen 37 aus der Phasenlage und Amplitude der mit der Auswerteeinrichtung 16 erfassten Spannung zu bestimmen. Die Auswerteeinrichtung 18 kann eingerichtet sein, um die gesamte Längsreaktanz des Transformators 40 als Differenz des Imaginärteils der Gesamtimpedanz und des Imaginärteils der Impedanz der Leitungen 37 zu bestimmen. Die Auswerteeinrichtung 18 kann eingerichtet sein, um die so bestimmte gesamte Längsreaktanz durch Skalierung mit dem Quadrat des Übersetzungsverhältnisses in eine ungestrichene Kenngröße des Transformators umzusetzen.

Bei einer weiteren Ausgestaltung kann die Auswerteeinrichtung 18 eingerichtet sein, um die gesamte Längsreaktanz des Transformators 40 aus der Gesamtimpedanz und dem Gesamtwiderstand zu bestimmen. Der Gesamtwiderstand kann durch eine statische Widerstandsmessung oder durch Auswertung der ersten und zweiten Testantwort ermittelt werden.

Die Auswerteeinrichtung 18 kann eingerichtet sein, um die gesamte Streuinduktivität des Transformators 40 zu ermitteln. Dazu kann die Auswerteeinrichtung 18 die Streureaktanz durch die Winkelfrequenz des Testsignals dividieren.

Die Vorrichtung 10 kann eingerichtet sein, um ein Übersetzungsverhältnis des Transformators 40 automatisch zu bestimmen und bei der Berechnung der Streureaktanz oder Streuinduktivität als ungestrichene Kenngröße zu berücksichtigen. Beispielsweise kann dazu die Quelle 13 als Wechselspannungsquelle betrieben und die Spannung an der Oberspannungsseite 41 erfasst werden, um das Übersetzungsverhältnis des Transformators zu bestimmen. Andere Techniken können zur Bestimmung des Übersetzungsverhältnisses eingesetzt werden.

Die Vorrichtung 10 kann eine Benutzerschnittstelle 20 umfassen. Die Benutzerschnittstelle 20 kann eine grafische Benutzerschnittstelle 20 sein, die eingerichtet ist, um eine benutzerdefinierte Festlegung von Messungen zu erlauben, die von der Vorrichtung 10 ausgeführt werden. Die Quelle 13 und/oder das steuerbare Schaltmittel 15 können zeitabhängig betätigt werden, um die Streureaktanz und/oder die Streuinduktivität des Transformators 40 zu bestimmen.

Die Vorrichtung 10 kann so eingerichtet sein, dass unterschiedliche Messungen erfolgen können, ohne dass die Verbindungen 35-38 zwischen der Vorrichtung 10 und dem Transformator 40 gelöst und/oder anders angeschlossen werden müssen. Die unterschiedlichen Messungen können ausgeführt werden, ohne dass der Prüfling umverdrahtet werden muss. Die Messungen können von der Vorrichtung 10 vollständig oder teilweise automatisiert, d.h. ohne Interaktion des Benutzers zwischen den Messungen, durchgeführt werden. Auf diese Weise kann beispielsweise sowohl die die Streureaktanz und/oder die Streuinduktivität des Transformators 40 bestimmt werden als auch wenigstens eine weitere Kenngröße, beispielsweise ein dynamischer oder statischer Widerstand, erfasst werden.

Die Vorrichtung 10 kann eingerichtet sein, um die mehreren unterschiedliche Messungen sequentiell auszuführen, wobei die Messungen und optional auch ihre Reihenfolge über die Schnittstelle 20 benutzerdefiniert festgelegt werden können. Über die Schnittstelle 20 kann beispielsweise ein Ersatzschaltbild des Transformators 40 dargestellt werden, in dem der Benutzer auswählen kann, welche Kenngrößen gemessen werden sollen. Alternativ oder zusätzlich kann die Auswerteeinrichtung 18 die Schnittstelle 20 so steuern, dass ein Ersatzschaltbild des Transformators 40 dargestellt wird, in dem die bestimmte Streureaktanz und/oder Streuinduktivität des Transformators 40 angegeben ist.

Während in Figur 1 eine Vorrichtung 10 dargestellt ist, bei der das steuerbare Schaltmittel 15 in die Vorrichtung 10 integriert ist, kann die Bestimmung der Streureaktanz und/oder der Streuinduktivität des Transformators 40 in einem Ausführungsbeispiel, das nicht unter die Erfindung fällt, auch erfolgen, wenn die Vorrichtung 10 kein steuerbares Schaltmittel zum Kurzschließen der Oberspannungsseite 41 aufweist.

Die Vorrichtung 10 kann eingerichtet sein, um weitere Verarbeitungsschritte abhängig von der bestimmten Streureaktanz und/oder Streuinduktivität auszuführen. Beispielsweise kann die Vorrichtung 10 eingerichtet sein, um Abweichungen zu den Nenndaten des Transformators 40 zu erkennen. Die Nenndaten können in einem Speicher der Vorrichtung 10 nicht-flüchtig hinterlegt. Die Nenndaten können von der Vorrichtung 10 automatisch von einem fernen Speicher abgerufen werden, beispielsweise über ein drahtloses oder drahtgebundenes Weitverkehrsnetz oder Lokalnetz. Alternativ oder zusätzlich kann die Vorrichtung 10 eingerichtet sein, um über die Schnittstelle 20 die Nenndaten zu empfangen. Die Vorrichtung 10 kann eingerichtet sein, um die Nenndaten abhängig von einer Benutzereingabe, mit der der Typ des Transformators angegeben wird, abzurufen und mit der ermittelten Streureaktanz und/oder der Streuinduktivität des Transformators 40 zu vergleichen. Die Vorrichtung 10 kann eingerichtet sein, um abhängig von dem Vergleich Information über eine Abweichung zwischen den Nenndaten und der ermittelten Streureaktanz und/oder der Streuinduktivität des Transformators 40 auszugeben.

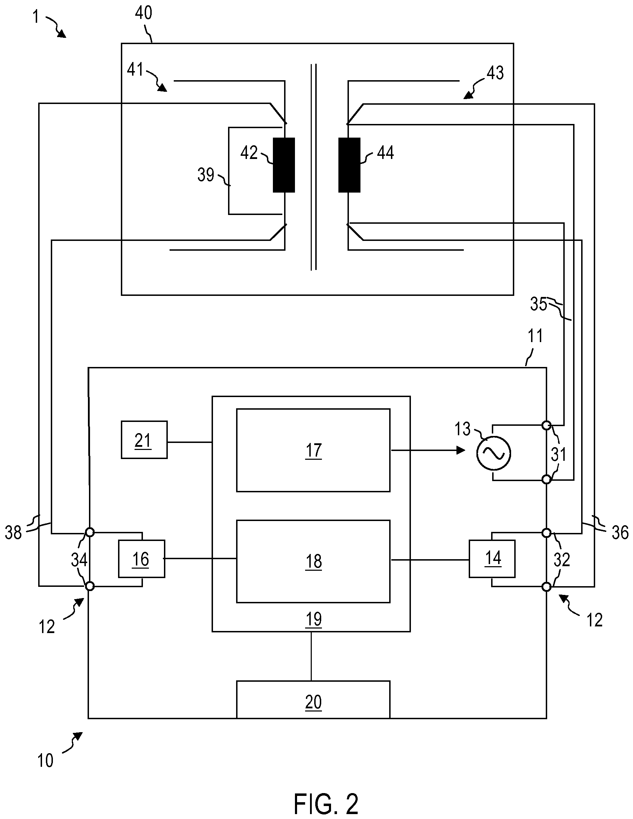

Figur 2 ist eine Darstellung eines Systems 1 mit einer Vorrichtung 10 nach einem weiteren Ausführungsbeispiel. Die Vorrichtung 10 kann, muss aber kein steuerbares Schaltmittel 15 zum Kurzschließen der Oberspannungsseite 41 aufweisen, wobei die Vorrichtung 10 nur dann unter die Erfindung fällt, wenn sie ein solches Schaltmittel 15 aufweist. Zur Bestimmung der Streureaktanz und/oder Streuinduktivität kann die Oberspannungswicklung 42 mit einer Leitung 39 kurzgeschlossen werden, so dass der Kurzschluss nicht über die Vorrichtung 10 führt.

Die weitere Ausgestaltung und Funktionsweise der Vorrichtung 10 kann wie unter Bezugnahme auf die Vorrichtung 10 von Figur 1 beschrieben sein.

Die Vorrichtung 10 kann eine Referenzsignalquelle 21 umfassen. Die Referenzsignalquelle 21 kann ein sinusförmiges oder anderes Wechselsignal mit einer Frequenz erzeugen, das der Frequenz des von der Quelle 13 erzeugten Testsignals entspricht. Die Auswerteeinrichtung 18 kann durch Bestimmung der Phasenlage des Testsignals relativ zu dem Referenzsignal der Referenzsignalquelle 21 und durch Bestimmung der Phasenlage der Testantwort relativ zu dem Referenzsignal der Referenzsignalquelle 21 eine Phasenverschiebung oder einen Zeitversatz zwischen Testantwort und Testsignal ermitteln.

Figur 3 und Figur 4 zeigen Ersatzschaltbilder zur Erläuterung der Funktionsweise der Vorrichtung nach einem Ausführungsbeispiel.

Figur 3 zeigt ein Ersatzschaltbild des Transformators 40. Der Wicklungswiderstand R₁ der Oberspannungsseite 41 kann durch einen Widerstand 51 repräsentiert werden. Der transformierte Wicklungswiderstand R₂' der Unterspannungsseite 43 kann durch einen Widerstand 54 repräsentiert werden. Die Streuinduktivität L_{σ1} der Oberspannungsseite 41 kann durch eine Induktivität 52 repräsentiert werden. Die transformierte Streuinduktivität L_{σ2}' der Unterspannungsseite 43 kann durch eine Induktivität 53 repräsentiert werden. Die Widerstände 51, 54 und Induktivitäten 52, 53 definieren die gesamte Längsinduktivität des Transformators. Die Induktivitäten 52, 53 definieren die nicht transformierte, d.h. ungestrichene, gesamte Streuninduktivität, die durch Skalierung mit dem Quadrat des Übersetzungsverhältnisses in an sich bekannter Weise in eine gestrichene Kenngröße des Transformators umgerechnet werden kann.

Eine den Magnetisierungsstrom führende Hauptinduktivität kann durch eine Induktivität 55 berücksichtigt werden. Eine lineare Modellierung von Verlusten im Transformatorkern kann durch einen Widerstand 56 erfolgen.

Die Vorrichtung nach einem Ausführungsbeispiel ist eingerichtet, das Testsignal an der Unterspannungsseite einzuprägen und abhängig von der Testantwort wenigstens die gesamte Längsreaktanz und/oder die gesamte Streuinduktivität des Transformators 40 zu bestimmen.

Figur 4 zeigt ein Ersatzschaltbild zur weiteren Erläuterung der Funktionsweise der Vorrichtung 10 nach Ausführungsbeispielen.

Die Vorrichtung 10 speist das Testsignal der Quelle 13 an der Unterspannungsseite des Transformators ein. Ein Voltmeter 65 oder eine andere Spannungsmesseinrichtung kann eine Spannung V_{L} an der Unterspannungsseite als eine erste Testantwort erfassen. Ein Voltmeter 66 oder eine andere Spannungsmesseinrichtung kann eine Spannung V_{H} an der Oberspannungsseite als eine zweite Testantwort erfassen. Die erste und zweite Testantwort kann beispielsweise wie oben beschrieben ausgewertet werden, um die Streureaktanz und/oder die Streuinduktivität des Transformators 40 zu bestimmen.

In Figur 4 ist die gesamte transformierte Längsimpedanz durch den Widerstand 61 und die Induktivität 62 dargestellt. Die Leitungen 37 zwischen der Vorrichtung 10 und dem Transformator 40 weisen eine Leitungsimpedanz auf, zu der ein Leitungswiderstand 63 und eine Leitungsinduktivität 64 beitragen können.

Durch Auswertung der Phasenlage und Amplitude der Spannung V_{H} an der Oberspannungsseite relativ zu dem Testsignal und durch Auswertung der Phasenlage und Amplitude der Spannung V_{L} an der Unterspannungsseite relativ zu dem Testsignal können der gesamte transformierte Längswiderstand 61 und die gesamte transformierte Längsreaktanz, die zur gesamten transformierten Streuinduktivität 62 proportional ist, ermittelt werden. Beispielsweise kann aus der Phasenlage und Amplitude der Spannung V_{H} an der Oberspannungsseite relativ zu dem Testsignal die Gesamtimpedanz ermittelt werden. Aus der Phasenlage und Amplitude der Spannung V_{H} an der Oberspannungsseite relativ zu dem Testsignal kann die Leitungsimpedanz ermittelt werden. Die transformierte Streureaktanz kann als Differenz der Imaginärteile von Gesamtimpedanz und Leitungsimpedanz bestimmt werden. Durch Skalierung mit dem Quadrat des Übersetzungsverhältnisses kann die Streureaktanz als nicht gestrichene Kenngröße des Transformators bestimmt werden.

Die Auswertungs- und Berechnungsschritte zur Bestimmung der Streureaktanz können von der Auswerteeinrichtung 18 automatisch ausgeführt werden.

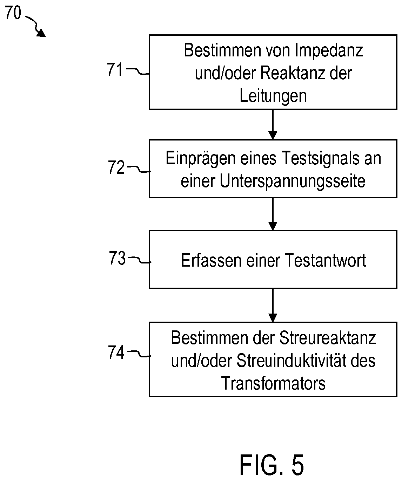

Figur 5 ist ein Flussdiagramm eines Verfahrens 70 nach einem Ausführungsbeispiel. Das Verfahren 70 kann von der Vorrichtung 10 nach einem Ausführungsbeispiel automatisch ausgeführt werden.

Bei Schritt 71 kann eine Leitungsimpedanz und/oder Leitungsreaktanz wenigstens einer Leitung zwischen der Vorrichtung 10 und dem Transformator 40 ermittelt werden. Dazu kann die Quelle 13 ein Testsignal erzeugen.

Bei Schritt 72 wird ein von der Quelle 13 erzeugtes Testsignal an der Unterspannungsseite des Transformators 40 eingeprägt. Das Testsignal kann ein Wechselstromsignal sein.

Bei Schritt 73 kann eine Testantwort des Transformators erfasst werden. Die Testantwort kann eine Wechselspannung über eine Oberspannungswicklung und eine weitere Wechselspannung über eine Unterspannungswicklung umfassen, die zeitabhängig erfasst werden.

Bei Schritt 74 werden die Streureaktanz und/oder die Streuninduktivität des Transformators 40 bestimmt. Die bestimmte Streureaktanz und/oder Streuninduktivität kann der gesamten Längsreaktanz bzw. der gesamten Streuinduktivität des Transformators entsprechen.

Das Verfahren 70 kann weitere Schritte beinhalten. Beispielsweise kann ein Übersetzungsverhältnis automatisch bestimmt werden. Das Übersetzungsverhältnis kann zur Umrechnung von transformierten Kenngrößen in nicht transformierte Kenngrößen verwendet werden.

Das Verfahren 70 kann die Auswertung einer Benutzereingabe umfassen, mit der benutzerdefiniert festlegbar ist, welche Kenngrößen des Transformators 40 bestimmt werden.

Das Verfahren 70 kann die Ansteuerung einer grafischen Benutzerschnittstelle derart, dass die ermittelte Streureaktanz und/oder Streuinduktivität dargestellt wird, umfassen.

Während Ausführungsbeispiele unter Bezugnahme auf die Figuren detailliert beschrieben wurden, können bei weiteren Ausführungsbeispielen alternative oder zusätzliche Merkmale verwendet werde. Während beispielsweise bestimmte Verarbeitungsschritte zur Ermittlung der Streureaktanz und/oder Streuinduktivität beispielhaft beschrieben wurden, können andere Verarbeitungstechniken eingesetzt werden. Beispielsweise kann die Streureaktanz und/oder die Streuinduktivität ermittelt werden, indem ein Matrix-Gleichungssystem nach Elementen einer Abbildungsmatrix gelöst wird, die die Sinus- und Kosinus-Komponenten des Testsignals in entsprechende Komponenten einer oder mehrerer Testantworten abbildet.

Während bei Ausführungsbeispielen die Vorrichtung ein steuerbares Schaltmittel zum Kurzschließen einer Wicklung des Transformators umfassen kann, kann die die auch zwei oder mehr als zwei steuerbare Schaltmittel zum Kurzschließen mehrerer Wicklungen des Transformators oder kein derartiges steuerbares Schaltmittel aufweisen. Die Vorrichtung kann eingerichtet sein, um mehrere Wicklungen gleichzeitig oder zeitsequentiell kurzzuschließen.

Während bei Ausführungsbeispielen eine Prozedur, die die Bestimmung mehrerer Kenngrößen des Transformators beinhaltet, automatisch ausgeführt werden kann, können die Vorrichtung und das Verfahr nach Ausführungsbeispielen auch verwendet werden, wenn nur eine Kenngröße des Transformators, beispielsweise nur die Streureaktanz, gemessen wird, bevor eine neue Benutzereingabe erforderlich ist.

Während der Transformator in einem Kraftwerk oder Umspannwerk eines Energieversorgungsnetzes installiert sein kann, können die Vorrichtung und das Verfahren nach Ausführungsbeispielen auch bei kleineren Transformatoren eingesetzt werden.

Vorrichtung, Verfahren und Systeme nach Ausführungsbeispielen erlauben eine Ermittlung von Kenngrößen wie der Streureaktanz und/oder Streuinduktivität mit einer weitergehenden Automatisierung bei der Transformatorprüfung.

## Patentansprüche

1. Vorrichtung (10) zum Ermitteln einer Kenngröße eines Transformators (40), der eine Oberspannungsseite (41) und eine Unterspannungsseite (43) aufweist, wobei die Vorrichtung (10) umfasst:
Anschlüsse (31) zur lösbaren Verbindung der Vorrichtung (10) mit der Unterspannungsseite (43) des Transformators (40),
weitere Anschlüsse (33, 34) zur lösbaren Verbindung der Vorrichtung (10) mit der Oberspannungsseite (41) des Transformators (40),
ein mit den weiteren Anschlüssen (33, 34) verbundenes steuerbares Schaltmittel (15) zum Kurzschließen der Oberspannungsseite (41),
eine Quelle (13) zum Erzeugen eines Testsignals, die mit den Anschlüssen (31) gekoppelt ist, um das Testsignal an der Unterspannungsseite (43) des Transformators (40) einzuprägen,
eine Steuereinrichtung (17), die eingerichtet ist, um die Quelle (13) und das steuerbare Schaltmittel (15) derart automatisch zu steuern, dass die Oberspannungsseite (41) durch das steuerbare Schaltmittel (15) kurzgeschlossen wird, während das Testsignal von der Quelle (13) an der Unterspannungsseite (43) eingeprägt wird, und
eine Auswerteeinrichtung (18), die eingerichtet ist, um die Streureaktanz und/oder
die Streuinduktivität des Transformators (40) in Abhängigkeit von der Testantwort des Transformators (40), welche erfasst wird während die Oberspannungsseite (41) durch das steuerbare Schaltmittel (15) kurzgeschlossen wird und das Testsignal von der Quelle (13) an der Unterspannungsseite (43) eingeprägt wird, zu bestimmen,
wobei die Auswerteeinrichtung (18) weiter eingerichtet ist, um abhängig von der bestimmten Streureaktanz und/oder der Streuinduktivität des Transformators (40) eine Abweichung von Nenndaten des Transformators (40) durch Vergleichen der bestimmten Streureaktanz und/oder Streuinduktivität mit den Nenndaten automatisch zu erkennen.

2. Vorrichtung nach Anspruch 1, umfassend
eine mit den weiteren Anschlüssen (33, 34) gekoppelte Messeinrichtung (16) zum Erfassen der Testantwort.

3. Vorrichtung nach Anspruch 1 oder Anspruch 2,
wobei die Auswerteeinrichtung (18) eingerichtet ist, um die Streureaktanz und/oder die Streuinduktivität des Transformators (40) in Abhängigkeit von der Testantwort und in Abhängigkeit von einer Reaktanz und/oder einer Induktivität wenigstens einer Leitung (37), die die weiteren Anschlüsse (33) mit der Oberspannungsseite (41) verbindet, zu bestimmen.

4. Vorrichtung nach Anspruch 3,
wobei die Auswerteeinrichtung (18) eingerichtet ist, um die Reaktanz und/oder die Induktivität der wenigstens einen Leitung (37) automatisch zu bestimmen.

5. Vorrichtung nach Anspruch 3 oder Anspruch 4,
wobei die Vorrichtung (10) eingerichtet ist, um die Reaktanz und/oder die Induktivität der wenigstens einen Leitung (37) ohne Umverdrahtung zwischen der Vorrichtung (10) und dem Transformator (40) zu bestimmen.

6. Vorrichtung nach einem der Ansprüche 1 bis 5,
wobei die Auswerteeinrichtung (18) weiterhin eingerichtet ist, um eine Kurzschlussimpedanz des Transformators (40) in Abhängigkeit von der Testantwort des Transformators (40) zu bestimmen.

7. Vorrichtung nach Anspruch 6,
wobei die Auswerteeinrichtung (18) eingerichtet ist, um die Kurzschlussimpedanz des Transformators (40) in Abhängigkeit von der Testantwort und in Abhängigkeit von einer Impedanz wenigstens einer Leitung (37), die die weiteren Anschlüsse mit der Oberspannungsseite (41) verbindet, zu bestimmen.

8. Vorrichtung nach einem der vorhergehenden Ansprüche, umfassend
eine Benutzerschnittstelle (20),
wobei die Auswerteeinrichtung (18) eingerichtet ist, um als Antwort auf eine Eingabe an der Benutzerschnittstelle (20) die Streureaktanz und/oder die Streuinduktivität des Transformators (40) zu ermitteln.

9. System, umfassend
einen Transformator (40), der eine Oberspannungsseite (41) und eine Unterspannungsseite (43) aufweist, und
eine Vorrichtung (10) nach einem der vorhergehenden Ansprüche, die mit dem Transformator (40) verbunden ist.

10. Verfahren zum Ermitteln einer Kenngröße eines Transformators (40), der eine Oberspannungsseite (41) und eine Unterspannungsseite (43) aufweist, umfassend
automatisches Kurzschließen der Oberspannungsseite (41) des Transformators (40) mit Hilfe eines steuerbaren Schaltmittels (15),
automatisches Einprägen eines Testsignals an der Unterspannungsseite (43), während die Oberspannungsseite (41) durch das steuerbare Schaltmittel (15) kurzgeschlossen wird,
Erfassen einer Testantwort des Transformators (40), während die Oberspannungsseite (41) durch das steuerbare Schaltmittel (15) kurzgeschlossen wird und das Testsignal an der Unterspannungsseite (43) eingeprägt wird,
Bestimmen einer Streureaktanz und/oder einer Streuinduktivität des Transformators (40) in Abhängigkeit von der Testantwort des Transformators (40), und
automatisches Erkennen einer Abweichung von Nenndaten des Transformators (40) abhängig von der bestimmten Streureaktanz und/oder der Streuinduktivität des Transformators (40) durch Vergleichen der bestimmten Streureaktanz und/oder Streuinduktivität mit den Nenndaten.

11. Verfahren nach Anspruch 10,
das mit der Vorrichtung (10) nach einem der Ansprüche 1 bis 8 ausgeführt wird.

## Claims

1. An apparatus (10) for determining a parameter of a transformer (40) which has a high-voltage side (41) and a low-voltage side (43), the apparatus (10) comprising
terminals (31) for detachably connecting the apparatus (10) to the low-voltage side (43) of the transformer (40),
further terminals (33, 34) for detachably connecting the apparatus (10) to the high-voltage side (41) of the transformer (40),
a controllable switching means (15) connected to the further terminals (33, 34) for short-circuiting the high-voltage side (41),
a source (13) for generating a test signal, coupled to the terminals (31), for impressing the test signal on the low-voltage side (43) of the transformer (40),
a control device (17) configured to automatically control the source (13) and the controllable switching means (15) such that the high-voltage side (41) is short-circuited by the controllable switching means (15) while the test signal from the source (13) is impressed on the low-voltage side (43), and
an evaluation device (18) which is configured to determine the leakage reactance and/or the leakage inductance of the transformer (40) on the basis of the test response of the transformer (40), which is detected while the high-voltage side (41) is short-circuited by the controllable switching means (15) and the test signal from the source (13) is impressed on the low-voltage side (43),
wherein the evaluation device (18) is further configured to automatically identify a deviation from nominal data of the transformer (40) on the basis of the determined leakage reactance and/or the leakage inductance of the transformer (40) by comparing the determined leakage reactance and/or leakage inductance with the nominal data.

2. The apparatus according to claim 1, comprising
a measuring device (16) coupled to the further terminals (33, 34) for detecting the test response.

3. The apparatus according to claim 1 or claim 2,
wherein the evaluation device (18) is configured to determine the leakage reactance and/or the leakage inductance of the transformer (40) on the basis of the test response and on the basis of a reactance and/or an inductance of at least one line (37) connecting the further terminals (33) to the high-voltage side (41).

4. The apparatus according to claim 3,
wherein the evaluation device (18) is configured to automatically determine the reactance and/or the inductance of the at least one line (37).

5. The apparatus according to claim 3 or claim 4,
wherein the apparatus (10) is configured to determine the reactance and/or the inductance of the at least one line (37) without rewiring between the apparatus (10) and the transformer (40).

6. The apparatus according to any one of claims 1 to 5,
wherein the evaluation device (18) is further configured to determine a short-circuit impedance of the transformer (40) on the basis of the test response of the transformer (40).

7. The apparatus according to claim 6,
wherein the evaluation device (18) is configured to determine the short-circuit impedance of the transformer (40) on the basis of the test response and on the basis of an impedance of at least one line (37) connecting the further terminals to the high-voltage side (41).

8. The apparatus according to any one of the preceding claims, comprising
a user interface (20),
wherein the evaluation device (18) is configured to determine the leakage reactance and/or the leakage inductance of the transformer (40) in response to an input at the user interface (20).

9. A system comprising
a transformer (40) having a high-voltage side (41) and a low-voltage side (43), and
an apparatus (10) according to any one of the preceding claims, connected to the transformer (40).

10. A method for determining a parameter of a transformer (40) which has a high-voltage side (41) and a low-voltage side (43), comprising
automatically short-circuiting the high-voltage side (41) of the transformer (40) by means of a controllable switching means (15),
automatically impressing a test signal on the low-voltage side (43) while the high-voltage side (41) is short-circuited by the controllable switching means (15),
detecting a test response of the transformer (40) while the high-voltage side (41) is short-circuited by the controllable switching means (15) and the test signal is impressed on the low-voltage side (43),
determining a leakage reactance and/or a leakage inductance of the transformer (40) on the basis of the test response of the transformer (40), and
automatically identifying a deviation from nominal data of the transformer (40) on the basis of the determined leakage reactance and/or leakage inductance of the transformer (40) by comparing the determined leakage reactance and/or leakage inductance with the nominal data.

11. The method according to claim 10,
which is carried out with the apparatus (10) according to any one of claims 1 to 8.

## Revendications

1. Dispositif (10) permettant de déterminer une caractéristique d'un transformateur (40) qui présente un côté haute tension (41) et un côté basse tension (43), dans lequel le dispositif (10) comprend :
des bornes (31) permettant de connecter de manière amovible le dispositif (10) au côté basse tension (43) du transformateur (40),
d'autres bornes (33, 34) permettant de connecter de manière amovible le dispositif (10) au côté haute tension (41) du transformateur (40),
un moyen de commutation (15) commandable, connecté aux autres bornes (33, 34) et permettant de court-circuiter le côté haute tension (41),
une source (13) permettant de générer un signal de test, laquelle est couplée aux bornes (31) afin d'appliquer le signal de test au côté basse tension (43) du transformateur (40),
un appareil de commande (17) qui est configuré pour commander automatiquement la source (13) et le moyen de commutation (15) commandable de telle sorte que le côté haute tension (41) est court-circuité par le moyen de commutation (15) commandable tandis que le signal de test provenant de la source (13) est appliqué au côté basse tension (43), et
un appareil d'évaluation (18) qui est configuré pour définir la réactance de fuite et/ou
l'inductance de fuite du transformateur (40) en fonction de la réponse de test du transformateur (40) qui est détectée pendant que le côté haute tension (41) est court-circuité par le moyen de commutation (15) commandable et que le signal de test provenant de la source (13) est appliqué au côté basse tension (43),
dans lequel l'appareil d'évaluation (18) est en outre configuré pour reconnaître automatiquement, en fonction de la réactance de fuite et/ou de l'inductance de fuite définies du transformateur (40), un écart par rapport à des données nominales du transformateur (40) en comparant la réactance de fuite et/ou l'inductance de fuite définies avec les données nominales.

2. Dispositif selon la revendication 1, comprenant
un appareil de mesure (16) couplé aux autres bornes (33, 34) et permettant de détecter la réponse de test.

3. Dispositif selon la revendication 1 ou la revendication 2,
dans lequel l'appareil d'évaluation (18) est configuré pour définir la réactance de fuite et/ou l'inductance de fuite du transformateur (40) en fonction de la réponse de test et en fonction d'une réactance et/ou d'une inductance d'au moins une ligne (37) qui connecte les autres bornes (33) au côté haute tension (41).

4. Dispositif selon la revendication 3, dans lequel l'appareil d'évaluation (18) est configuré pour définir automatiquement la réactance et/ou l'inductance de l'au moins une ligne (37).

5. Dispositif selon la revendication 3 ou la revendication 4,
dans lequel le dispositif (10) est configuré pour définir la réactance et/ou l'inductance de l'au moins une ligne (37) sans changement de câblage entre le dispositif (10) et le transformateur (40).

6. Dispositif selon l'une des revendications 1 à 5,
dans lequel l'appareil d'évaluation (18) est en outre configuré pour définir une impédance de court-circuit du transformateur (40) en fonction de la réponse de test du transformateur (40).

7. Dispositif selon la revendication 6,
dans lequel l'appareil d'évaluation (18) est configuré pour définir l'impédance de court-circuit du transformateur (40) en fonction de la réponse de test et en fonction d'une impédance d'au moins une ligne (37) qui connecte les autres bornes au côté haute tension (41).

8. Dispositif selon l'une des revendications précédentes, comprenant
une interface utilisateur (20),
dans lequel l'appareil d'évaluation (18) est configuré pour déterminer la réactance de fuite et/ou l'inductance de fuite du transformateur (40) en réponse à une entrée sur l'interface utilisateur (20).

9. Système, comprenant
un transformateur (40) qui présente un côté haute tension (41) et un côté basse tension (43), et
un dispositif (10) selon l'une des revendications précédentes qui est connecté au transformateur (40).

10. Procédé permettant de déterminer une caractéristique d'un transformateur (40) qui présente un côté haute tension (41) et un côté basse tension (43), comprenant
le fait de court-circuiter automatiquement le côté haute tension (41) du transformateur (40) à l'aide d'un moyen de commutation (15) commandable,
l'application automatique d'un signal de test sur le côté basse tension (43) tandis que le côté haute tension (41) est court-circuité par le moyen de commutation (15) commandable,
la détection d'une réponse de test du transformateur (40) tandis que le côté haute tension (41) est court-circuité par le moyen de commutation (15) commandable et que le signal de test est appliqué au côté basse tension (43),
la définition d'une réactance de fuite et/ou d'une inductance de fuite du transformateur (40) en fonction de la réponse de test du transformateur (40), et la reconnaissance automatique d'un écart par rapport à des données nominales du transformateur (40) en fonction de la réactance de fuite et/ou de l'inductance de fuite définies du transformateur (40) en comparant la réactance de fuite et/ou l'inductance de fuite définies avec les données nominales.

11. Procédé selon la revendication 10,
lequel est exécuté par le dispositif (10) selon l'une des revendications 1 à 8.
